# FASCICULE DE BREVET EUROPEEN

(11) **EP 4 222 130 B1**
(45) Date de publication et mention de la délivrance du brevet: **27.11.2024**
(21) Numéro de dépôt: 21785967.7
(22) Date de dépôt: 20.09.2021
(51) Int. Cl.: C04B 41/00, C04B 41/45, C04B 41/52, C04B 41/87, C04B 41/89, F01D 5/28, C23C 16/40, C23C 16/448

(54) **PROCEDE DE FABRICATION D'UNE BARRIERE ENVIRONNEMENTALE**
VERFAHREN ZUR HERSTELLUNG EINER UMWELTBARRIERE
METHOD FOR MANUFACTURING AN ENVIRONMENTAL BARRIER

(30) Priorité: 29.09.2020 FR 2009876
(43) Date de publication de la demande: 09.08.2023
(73) Titulaire: Safran Ceramics, 33185 Le Haillan (FR); Centre national de la recherche scientifique, 75016 Paris (FR); UNIVERSITE DE BORDEAUX, 33000 Bordeaux (FR)
(72) Inventeur: DELEHOUZE, Arnaud, 77550 MOISSY-CRAMAYEL (FR); BOUILLON, Eric, 77550 MOISSY-CRAMAYEL (FR); JACQUES, Sylvain Lucien, 33400 TALENCE (FR)
(74) Mandataire: Cabinet Beau de Loménie
(86) Numéro de dépôt international: PCT/FR2021/051596
(87) Numéro de publication internationale: WO 2022/069812

(56) Documents cités:
- FR-A1- 2 899 226
- JONES A J ET AL: "MOCVD OF ZIRCONIA THIN FILMS BY DIRECT LIQUID IMJECTION USING A NEW CLASS OF ZIRCONIUM PRECURSOR", CHEMICAL VAPOR DEPOSITION, WILEY-VCH VERLAG, WEINHEIM, DE, vol. 4, no. 2, 1 March 1998 (1998-03-01), pages 46 - 49, XP000738248, ISSN: 0948-1907, DOI: 10.1002/(SICI)1521-3862(199803)04:02<46::AID-CVDE46>3.0.CO;2-1

## Description

### Domaine Technique

Un domaine particulier d'application de l'invention est la protection de matériaux composites à matrice au moins partiellement en céramique (« matériaux CMC ») formant des parties chaudes de turbines à gaz, telles que des parois de chambre de combustion, ou des anneaux de turbine, des distributeurs de turbine ou des aubes de turbines, pour des moteurs aéronautiques ou des turbines industrielles.

### Technique antérieure

L'amélioration du rendement et la réduction des émissions polluantes conduit à envisager des températures toujours plus élevées dans les chambres de combustion. Il a donc été proposé de remplacer les matériaux métalliques par des matériaux CMC, notamment pour des parois de chambres de combustion ou anneaux de turbine. En effet, les matériaux CMC sont connus pour posséder à la fois de bonnes propriétés mécaniques permettant leur utilisation pour des éléments de structure et la capacité de conserver ces propriétés à des températures élevées. Les matériaux CMC peuvent comporter un renfort fibreux en fibres réfractaires, typiquement en carbone ou en céramique, qui est densifié par une matrice céramique, par exemple en carbure de silicium.

Dans les conditions de fonctionnement des turbines aéronautiques, c'est-à-dire à haute température sous atmosphère oxydante et humide, les matériaux CMC sont sensibles au phénomène de corrosion. La corrosion du CMC résulte de l'oxydation du carbure de silicium en silice qui, en présence de vapeur de d'eau, se volatilise sous forme d'hydroxydes de silicium Si(OH)₄. Les phénomènes de corrosion entraînent une récession du CMC et affectent la durée de vie de ce dernier. Afin de limiter cette dégradation en fonctionnement, il a été envisagé de former à la surface des matériaux CMC des barrières environnementales (« Environmental Barrier Coating » ; « EBC »). Les barrières environnementales peuvent comporter une couche de liaison en silicium ainsi qu'une couche de silicate de terre rare positionnée sur la couche de liaison. La couche de liaison permet, d'une part, d'améliorer l'accroche de la couche de silicate de terre rare et, d'autre part, de former une couche de silice protectrice, dont la faible perméabilité à l'oxygène participe à la protection du CMC contre l'oxydation. La couche de silicate de terre rare permet, quant à elle, de limiter la diffusion de la vapeur d'eau vers la couche de silice formée par oxydation du silicium et par conséquent de limiter la récession de celle-ci. Les barrières environnementales peuvent être déposées par projection thermique. On connaît en particulier US2019040761 qui décrit la formation d'une EBC par une telle méthode. On connaît aussi FR2899226A1 qui décrit la formation d'une EBC par dépôt chimique en phase vapeur. 11

Il reste néanmoins souhaitable d'améliorer encore la protection des matériaux CMC en milieu oxydant et corrosif à haute température, notamment supérieure ou égale à 800°C.

### Exposé de l'invention

La présente invention concerne un procédé de fabrication d'une pièce à résistance améliorée à l'oxydation et à la corrosion à haute température, comprenant au moins la formation d'une couche de barrière environnementale sur un matériau composite à matrice au moins partiellement en céramique, ladite couche de barrière environnementale étant formée par dépôt chimique en phase vapeur de composé(s) organométallique(s) par injection directe liquide.

L'invention repose sur l'utilisation d'une technique de dépôt particulière, à savoir le dépôt chimique en phase vapeur de composé(s) organométallique(s) par injection directe liquide_(« Direct Liquid Injection-Metal Organic Chemical Vapor Déposition » ; « DLI-MOCVD ») qui utilise un ou plusieurs précurseurs moléculaires, pour réaliser une barrière environnementale sur un matériau CMC. Dans la suite et pour des raisons de concision cette technique sera désignée par « technique DLI-MOCVD ». La technique DLI-MOCVD est utilisée dans le domaine des semi-conducteurs, comme divulgué dans l'article de Jones et AI. "MOCVD of Zirconia Thin Films by Direct Liquid injection Using a New Class of Zirconium Precursor" (Chem. Vap. Déposition, 1998, 4, No. 2, pp. 46-49), mais, à la connaissance des inventeurs, n'a pas été mise en oeuvre pour élaborer une barrière environnementale protégeant un matériau CMC.

Les barrières environnementales obtenues par la technique DLI-MOCVD présentent moins de porosités résiduelles et de microfissures et une composition et microstructure mieux maîtrisées que les barrières environnementales obtenues par projection thermique. De la sorte les barrières environnementales obtenues dans le cadre de l'invention sont plus étanches (moins poreuses) et présentent moins de contraintes internes en fonctionnement associées aux différences de dilatation entre le composé barrière souhaité et des composés non souhaités aussi présents (composition mieux contrôlée). L'emploi de la technique DLI-MOCVD permet aussi de mieux maîtriser la composition du dépôt obtenu, par rapport à la mise en oeuvre d'un dépôt chimique en phase vapeur CVD classique (« Chemical Vapor Déposition » ; « CVD »), et en particulier de moduler la composition du dépôt en adaptant les quantités utilisées pour les différents précurseurs si cela est souhaité. Il est aussi possible de déposer des phases pures et non des phases mixtes de type disilicate de terre rare/monosilicate de terre rare comme en projection thermique. Le fait d'avoir une barrière environnementale plus performante, moins poreuse notamment, permet d'en réduire l'épaisseur, ce qui favorise la compatibilité des coefficients de dilatation thermique entre la barrière environnementale et le matériau sous-jacent. La réalisation de dépôts d'épaisseur réduite est en outre particulièrement avantageuse pour certaines pièces où il est recherché de maintenir au moins localement une épaisseur très fine malgré la présence du dépôt protecteur, par exemple dans le cas d'un bord de fuite d'une aube, ainsi que pour la réalisation de dépôts multicouches fins (de l'ordre de 10 µm par couche par exemple), ces dépôts multicouches facilement réalisables en projection thermique. En outre l'invention présente l'avantage de permettre l'utilisation satisfaisante de précurseurs sous forme liquide ou solide dont l'évaporation et l'entraînement à l'état gazeux peuvent être difficiles à réaliser ou à maîtriser dans le cadre d'un procédé de dépôt chimique en phase vapeur CVD classique. La technique DLI-MOCVD permet aussi de s'affranchir de l'emploi de précurseurs chlorures métalliques qui sont en général générés à l'état gazeux *in situ* dans les procédés de CVD classique, cette génération étant relativement complexe à maîtriser ainsi que la gestion du débit, et pouvant générer de l'acide chlorhydrique en tant que sous-produit de réaction qui est corrosif et peut dégrader l'installation de dépôt.

La couche de barrière environnementale obtenue dans le cadre de l'invention peut avoir une composition quelconque. La couche de barrière environnement peut ainsi comprendre au moins un silicate de terre rare, de la zircone stabilisée par un oxyde de terre rare ou de la mullite (3Al₂O₃.2SiO₂).

Dans un exemple de réalisation, la couche de barrière environnementale comprend un silicate de terre rare et est formée au moins à partir d'un précurseur d'oxyde de silicium alcoxysilane et d'un précurseur d'oxyde de terre rare béta-dicétonate de terre rare en présence d'une source gazeuse apporteuse d'oxygène. En particulier, le précurseur d'oxyde de silicium peut être le di-t-butoxydiacétoxysilane et le précurseur d'oxyde de terre rare RE(thd)₃, où RE désigne un élément terre rare et le groupement (thd) désigne le 2,2,6,6-tetraméthyl-3,5-heptanedionate, le précurseur d'oxyde de terre rare étant par exemple Y(thd)₃ (CAS n° 15632-39-0).

Ces associations de précurseurs sont avantageuses car RE(thd)₃ peut être facilement obtenu dans le commerce, est relativement simple d'utilisation et stable thermiquement ce qui permet de réaliser des dépôts à haute température et donc d'obtenir des vitesses de croissance élevées, et le di-t-butoxydiacétoxysilane présente une température de décomposition assez proche de RE(thd)₃. Ces deux précurseurs sont aussi miscibles, ce qui permet de les utiliser dissous dans un même solvant si cela est souhaité.

La source gazeuse apporteuse d'oxygène peut comporter l'un au moins des gaz suivants : O₂, N₂O, H₂O, CO₂, O₃.

Dans un exemple de réalisation, la nature et/ou les proportions relatives de précurseurs moléculaires sont modifiées durant la formation de la couche de barrière environnementale de sorte à lui conférer une composition évolutive.

La technique DLI-MOCVD permet de moduler de manière fine et continue la composition de la couche de barrière environnementale pendant son dépôt afin de lui conférer des propriétés améliorées. On notera que l'on peut aussi déposer plusieurs couches de barrière environnementale successives et de composition bien définie et distincte.

En particulier, la formation de la couche de barrière environnementale peut comprendre au moins la formation d'une première portion comprenant un disilicate de terre rare, et la formation d'une deuxième portion comprenant un monosilicate de terre rare sur la première portion.

Le fait de positionner le monosilicate du côté externe de la barrière environnementale permet d'améliorer davantage encore la tenue de la barrière environnementale à la récession dans la mesure où les monosilicates de terre rare sont moins sensibles à ce phénomène que les disilicates de terre rare.

En variante, la formation de la couche de barrière environnementale comprend au moins la formation d'une première portion comprenant un monosilicate de terre rare, et la formation d'une deuxième portion comprenant un disilicate de terre rare sur la première portion.

En variante ou en combinaison, la formation de la couche de barrière environnementale comprend au moins la formation d'une première portion comprenant un silicate d'un premier terre rare, et la formation d'une deuxième portion comprenant un silicate d'un deuxième terre rare, différent du premier terre rare, les première et deuxième portions étant superposées.

Le fait de faire varier la nature du terre rare le long de la barrière environnementale permet d'améliorer sa tenue chimique. Par exemple, la première portion peut comprendre un disilicate d'ytterbium ou un disilicate d'yttrium et d'ytterbium, et la deuxième portion un monosilicate d'yttrium ou un disilicate de lutécium. Ainsi, la première portion apporte une protection améliorée à la corrosion et la deuxième portion une tenue améliorée aux aluminosilicates de calcium et de magnésium (CMAS).

Dans un exemple de réalisation, l'épaisseur de la couche de barrière environnementale est inférieure ou égale à 1000 µm, par exemple inférieure ou égale à 700 µm.

La technique DLI-MOCVD permet de réduire l'épaisseur des barrières environnementales dans la mesure où ces dernières ont de meilleures propriétés. L'épaisseur de la couche de barrière environnementale peut être supérieure ou égale à 200 µm, par exemple comprise entre 200 µm et 1000 µm, par exemple entre 200 µm et 700 µm.

Dans un exemple de réalisation, le procédé comprend le dépôt d'une couche d'accrochage comprenant du silicium sur la surface externe du matériau composite à matrice au moins partiellement en céramique, et la couche de barrière environnementale est déposée sur ladite couche d'accrochage. Cette couche d'accrochage peut être déposée par dépôt chimique en phase vapeur.

Dans un exemple de réalisation, on réalise en outre un traitement thermique de cristallisation de la couche de barrière environnementale formée.

Suivant la température d'élaboration, la barrière environnementale peut être amorphe. Ce traitement de cristallisation permet alors de cristalliser le dépôt et de moduler la taille de grains *in fine.*

La température imposée durant le traitement thermique de cristallisation peut être supérieure ou égale à 1250°C, par exemple à 1350°C. Cette température peut être inférieure ou égale à 1400°C, par exemple si une couche d'accrochage en silicium est présente afin d'éviter tout risque de faire fondre celle-ci.

Le brevet décrit également une pièce fabriquée par mise en oeuvre d'un procédé tel que décrit plus haut, la pièce étant une pièce de turbomachine.

### Brève description des dessins

[Fig. 1] La figure 1 illustre, de manière schématique, un premier exemple de pièce à résistance améliorée à l'oxydation et à la corrosion à haute température pouvant être obtenue par mise en oeuvre de l'invention.
[Fig. 2] La figure 2 illustre, de manière schématique, un deuxième exemple de pièce à résistance améliorée à l'oxydation et à la corrosion à haute température pouvant être obtenue par mise en oeuvre de l'invention.

### Description des modes de réalisation

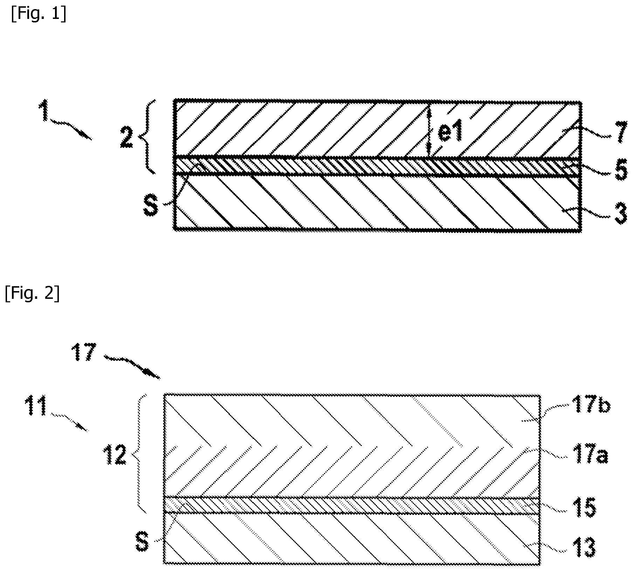

La figure 1 montre un exemple de pièce 1 comprenant un matériau 3 CMC muni d'une barrière environnementale 2 qui peut être obtenue par mise en oeuvre de l'invention.

Le matériau 3 CMC peut comprendre un renfort fibreux qui peut être en fibres de carbone (C) ou en fibres céramiques, par exemple en fibres de carbure de silicium (SiC) ou formées essentiellement de SiC, incluant des fibres en Si-C-O ou Si-C-O-N, c'est-à-dire contenant aussi de l'oxygène et éventuellement de l'azote. De telles fibres sont produites par la société Nippon Carbon sous la référence « Nicalon » ou « Hi-Nicalon » ou « Hi-Nicalon Type-S », ou par la société Ube Industries sous la référence « Tyranno-ZMI ». Les fibres céramiques peuvent être revêtues d'une mince couche d'interphase en carbone pyrolytique (PyC), en nitrure de bore (BN) ou en carbone dopé au bore (BC, avec 5%at. à 20%at. de B, le complément étant C). Le renfort fibreux est densifié par une matrice au moins partiellement céramique, par exemple majoritairement en volume en céramique. La matrice céramique peut comprendre du carbure de silicium ou un système ternaire Si-B-C, par exemple. La matrice peut être au moins en partie formée par CVI de manière connue en soi. En variante, la matrice peut être au moins en partie formée par voie liquide (imprégnation par une résine précurseur de la matrice et transformation par réticulation et pyrolyse, le processus pouvant être répété) ou par infiltration de silicium à l'état fondu (procédé de « Melt-Infiltration »). Dans ce dernier cas, une poudre est introduite dans le renfort fibreux éventuellement partiellement densifié, cette poudre pouvant être une poudre de carbone, de céramique par exemple de carbure de silicium, ou un mélange de telles poudres, et une composition métallique à base de silicium à l'état fondu est ensuite infiltrée pour former une matrice de type SiC-Si. Le renfort fibreux peut être tissé ou non, on ne sort pas du cadre de l'invention lorsque le renfort fibreux est sous la forme de fibres courtes dispersées dans le matériau 3. On peut en variante utiliser un renfort particulaire sous la forme de grains dispersés dans le matériau 3.

La barrière environnementale 2 peut être formée sur toute la surface externe S du matériau 3 CMC ou sur une partie seulement de cette surface S, par exemple lorsque seulement une partie de la surface S doit être protégée. Dans l'exemple illustré à la figure 1, la barrière environnementale 2 comprend une couche 7 de barrière environnementale et une couche 5 d'accrochage présente entre le matériau 3 CMC et la couche 7. Dans l'exemple illustré, la couche 5 d'accrochage est présente au contact de la surface S du matériau composite 3. En outre, dans cet exemple, la couche 7 est au contact de la couche 5 d'accrochage.

La couche 5 d'accrochage peut de manière connue en soi former en fonctionnement une couche de silice protectrice contre l'oxydation (couche dite de « TGO » pour « Thermally Grown Oxide »). La couche 5 d'accrochage peut être en silicium.

La couche 7 est une couche de barrière environnementale apportant une protection contre l'oxydation et la corrosion à haute température en limitant notamment la diffusion de la vapeur d'eau et de l'oxygène vers la couche 5 d'accrochage et le matériau 3 CMC. La couche 7 peut comporter un silicate de terre rare par exemple un monosilicate de terre rare et/ou un disilicate de terre rare, de la zircone stabilisée par un oxyde de terre rare par exemple par de l'oxyde d'yttrium, ou de la mullite.

La couche 7 peut comporter au moins un élément terre rare choisi parmi l'yttrium Y, le scandium Sc et les lanthanides. En particulier, l'élément terre rare peut être choisi parmi l'yttrium Y et l'ytterbium Yb. On notera que l'on ne sort pas du cadre de l'invention si la couche 7 comprend plusieurs éléments terres rares, par exemple de l'yttrium et de l'ytterbium.

La couche 7 peut avoir une microstructure équiaxe, qui favorise la résistance mécanique et la ténacité. En variante, la couche 7 peut avoir une microstructure colonnaire, favorisant la résistance aux chocs thermiques.

L'épaisseur e₁ de la couche 7 peut être supérieure ou égale à 50 µm, par exemple supérieure ou égale à 200 µm, par exemple supérieure ou égale à 250 µm. Cette épaisseur e₁ peut être comprise entre 50 µm et 1000 µm, par exemple entre 200 µm et 1000 µm ou entre 250 µm et 1000 µm, par exemple entre 200 µm et 700 µm ou entre 250 µm et 700 µm. La couche 7 forme un revêtement recouvrant la surface externe S du matériau 3 CMC, l'épaisseur e₁ est mesurée depuis cette surface externe.

On va maintenant décrire des détails relatifs à la fabrication de la barrière environnementale. Le passage qui va être, à présent, abordé fournit des détails relatifs à la formation de la couche 5 d'accrochage.

La couche 5 d'accrochage peut être formée par dépôt chimique en phase vapeur à partir d'un précurseur comprenant du silicium comprenant par exemple un silane, un monochlorosiliane, un dichlorosilane, et/ou un trichlorosilane. Deux exemples de formation de la couche 5 d'accrochage par dépôt chimique en phase vapeur sont décrits ci-dessous.

Selon un premier exemple, la température imposée durant le dépôt de la couche 5 d'accrochage peut être comprise entre 900°C et 1150°C, par exemple entre 1100°C et 1150°C, et la pression imposée lors de ce dépôt peut être comprise entre 15,3 kPa et 20 kPa, par exemple entre 16,7 kPa et 18 kPa. Lors du dépôt, le précurseur comprenant du silicium peut être introduit dans la chambre réactionnelle dans laquelle le matériau 3 CMC est présent avec un débit compris entre 0,05 gramme/minute et 0,3 gramme/minute, par exemple entre 0,1 gramme/minute et 0,2 gramme/minute. Selon ce premier exemple, la couche 5 d'accrochage obtenue a une microstructure cristalline. En particulier, la couche 5 d'accrochage peut être en silicium, cette couche 5 d'accrochage comprenant par exemple des grains colonnaires de silicium cristallin. En variante, la couche 5 d'accrochage peut être en alliage de silicium, par exemple en alliage eutectique de silicium ou en siliciure. Selon un deuxième exemple, la couche 5 d'accrochage comprend une phase de silicium amorphe ayant des grains de silicium cristallin distribués à l'intérieur, ces grains pouvant avoir une taille moyenne comprise entre 0,03 µm et 3 µm. La phase de silicium amorphe peut être formée de silicium pur ou de silicium avec du bore, de l'oxygène et/ou de l'azote dispersés à l'intérieur. Selon ce deuxième exemple, la couche 5 d'accrochage peut être formée à une température de dépôt qui empêche la cristallisation du silicium déposé, suivi d'un traitement thermique de la couche d'accrochage à une température de traitement supérieure à la température imposée lors du dépôt afin de former les grains de silicium cristallin distribués dans la phase de silicium amorphe. La température imposée lors du dépôt peut être comprise entre 300°C et 700°C ou entre 700°C et 1000°C, et la pression imposée lors du dépôt peut être comprise entre 1,2 kPa et 1 013 hPa. Les conditions opératoires sont choisies en fonction du précurseur utilisé. La température de traitement peut être comprise entre 1000°C et 1400°C, par exemple entre 1200°C et 1350°C. Lors du dépôt, le précurseur comprenant du silicium peut être introduit dans la chambre réactionnelle dans laquelle le matériau 3 CMC est présent avec un débit compris entre 0,1 gramme/minute et 2 gramme/minute.

On ne sort pas du cadre de l'invention lorsqu'un procédé autre que le dépôt chimique en phase vapeur est utilisé pour former la couche 5 d'accrochage, celle-ci pouvant par exemple en variante être formée par projection thermique à partir d'une poudre ou un mélange de poudres ayant la composition désirée.

La description se poursuit par la fourniture de détails relatifs à la fabrication de la couche 7 de barrière environnementale.

Dans la technique DLI-MOCVD, les précurseurs moléculaires de la couche 7 de barrière environnementale à obtenir sont présents à l'état liquide, en étant éventuellement dissous dans un solvant organique, dans au moins un réservoir de stockage. Chacun des précurseurs moléculaires peut être présent dans un réservoir distinct, ou, si les précurseurs moléculaires sont miscibles, ces derniers peuvent être présents dans un même réservoir de stockage. Les précurseurs peuvent ainsi être dissous dans un même solvant organique (liquide) dans un même réservoir de stockage. Le solvant peut par exemple être le toluène ou mésitylène.

Pour réaliser le dépôt de la couche 7, les précurseurs moléculaires à l'état liquide sont injectés sous forme de gouttelettes liquides dans une chambre de détente qui est chauffée à une température telle que les précurseurs sont vaporisés sans provoquer leur décomposition. On peut utiliser par exemple une chambre de détente telle que décrite dans le document US 2009078791. L'apport des précurseurs moléculaires à l'état liquide dans la chambre de détente peut être régulé par un débitmètre liquide. On obtient dans la chambre de détente une phase vapeur comprenant un mélange de précurseurs moléculaires à l'état gazeux par évaporation flash des précurseurs liquides. Cette phase vapeur est entraînée par un gaz vecteur (comme de l'argon ou de l'azote) vers la chambre réactionnelle dans laquelle le matériau 3 CMC est présent. Le matériau 3 CMC est chauffé à une température suffisante pour permettre la décomposition des précurseurs moléculaires en présence éventuellement d'une source gazeuse apporteuse d'oxygène comme évoqué plus haut. On forme ainsi la couche 7 de barrière environnementale sur le matériau 3 CMC. La chambre réactionnelle peut être un réacteur à parois chaudes ou à parois froides. Ce dernier cas est avantageux afin de favoriser à haute température la formation rapide du dépôt sur le matériau 3 CMC et non les réactions homogènes en phase gazeuse tout en respectant la température de dégradation des précurseurs.

La composition de la couche 7 obtenue est fonction des précurseurs moléculaires utilisés et de leurs proportions relatives introduites dans la chambre réactionnelle.

L'homme du métier sait choisir les précurseurs moléculaires à mettre en oeuvre parmi des précurseurs connus en soi pour la technique DLI-MOCVD afin d'obtenir la couche 7. Les conditions opératoires à mettre en oeuvre pour le dépôt sont déterminées par l'homme du métier de manière empirique et par une méthodologie connue. Par exemple, l'homme du métier peut réaliser plusieurs dépôts en modulant les débits des précurseurs moléculaires, puis caractériser ces dépôts et affiner ensuite, si cela est nécessaire, les paramètres de débit, température et pression afin d'obtenir la couche 7 souhaitée.

Selon un exemple, la couche 7 peut comprendre un silicate de terre et être formée au moins à partir d'un précurseur moléculaire d'oxyde de silicium, et d'un précurseur moléculaire d'oxyde de terre rare en présence d'une source gazeuse apporteuse d'oxygène telle que décrite plus haut.

Selon un autre exemple, la couche 7 peut comprendre de la mullite et être formée au moins à partir d'un précurseur moléculaire d'oxyde de silicium, et d'un précurseur moléculaire d'oxyde d'aluminium en présence d'une source gazeuse apporteuse d'oxygène telle que décrite plus haut.

Quel que soit l'exemple considéré, le précurseur moléculaire d'oxyde de silicium peut être un alcoxysilane, par exemple l'orthosilicate de tétraéthyle (TEOS) ou le di-t-butoxydiacétoxysilane (DADBS).

Le précurseur moléculaire d'oxyde d'aluminium peut être l'association du triméthylaluminium (TMA) avec la source gazeuse apporteuse d'oxygène, ou un alcoxyde d'aluminium (par exemple l'aluminium tris-iso-propoxide, Al(OiPr)₃), ou un β-dicétonate d'aluminium (par exemple l'aluminium acétylacétonate, Al(acac)₃). Selon un autre exemple, la couche 7 peut comprendre de la zircone stabilisée par un oxyde de terre rare, par exemple de la zircone yttriée, et être formée au moins à partir d'un précurseur moléculaire d'oxyde de zirconium et d'un précurseur moléculaire d'oxyde de terre rare en présence d'une source gazeuse apporteuse d'oxygène telle que décrite plus haut.

Le précurseur d'oxyde de zirconium peut être choisi parmi : les alcoxydes de zirconium ou les béta-dicétonates de zirconium. A titre d'exemple d'alcoxyde de zirconium utilisable, on peut citer le tetra-tert-butoxyde de zirconium Zr(OtBu)₄, le tetra-butoxyde de zirconium Zr(OnBu)₄ ou le tetra-propoxyde de zirconium Zr(OnPr)₄. A titre d'exemple de béta-dicétonate de zirconium utilisable, on peut citer le Zr(thd)₄.

Quel que soit l'exemple considéré, le précurseur moléculaire d'oxyde de terre rare peut être choisi parmi : les alcoxydes de terre rare ou les béta-dicétonates de terre rare. A titre d'exemple d'alcoxyde de terre rare utilisable, on peut citer le RE(mmp)₃ où RE désigne un élément terre rare et le groupement (mmp) le 1-méthoxy-2-méthyl-2-propanolato. A titre d'exemple de béta-dicétonate de terre rare utilisable, on peut citer le RE(thd)₃ où RE désigne un élément terre rare.

Comme indiqué plus haut, les précurseurs moléculaires sont à l'état liquide. Ces précurseurs peuvent être dissous dans un solvant s'ils sont à l'état solide dans les conditions standard de température et de pression (pression de 1 bar et température de 20°C). Par exemple, le précurseur moléculaire d'oxyde de terre rare Y(thd)₃ est disponible sous forme solide et peut être dissous dans le toluène ou le mésitylène ou encore dans le benzène. D'autres précurseurs moléculaires, comme les alcoxysilanes, peuvent, quant à eux, déjà être à l'état liquide dans les conditions standard de température et de pression.

A titre d'exemple, on peut mettre en oeuvre les conditions opératoires suivantes lors de la formation de la couche 7 de barrière environnementale :
- la température de la chambre réactionnelle dans laquelle le matériau 3 CMC est présent peut être comprise entre 600°C et 1200°C, par exemple entre 800°C et 1100°C, par exemple entre 800°C et 1000°C, et
- la pression dans la chambre réactionnelle peut être inférieure ou égale à 1000 mbar, par exemple inférieure ou égale à 100 mbar, par exemple inférieure ou égale à 20 mbar. La pression dans la chambre réactionnelle peut être comprise entre 0,3 mbar et 1000 mbar, par exemple entre 2 mbar et 100 mbar, par exemple entre 2 mbar et 20 mbar.

Dans le cas d'une couche 7 comprenant un silicate de terre rare, le rapport [quantité de matière de précurseur moléculaire d'oxyde de silicium injecté dans la chambre de détente] / [quantité de matière de précurseur moléculaire d'oxyde de terre rare injecté dans la chambre de détente] peut être compris entre 0,1 et 10, par exemple entre 0,2 et 5. Les quantités de matière sont mesurées en moles (mol). En outre, le rapport [quantité de matière de source gazeuse apporteuse d'oxygène mise en oeuvre] / [quantité de matière de précurseurs à l'état liquide mise en oeuvre] peut être compris entre 0,1 et 10, par exemple entre 0,5 et 5. La quantité de matière de précurseurs à l'état liquide correspond à la quantité de matière de solvant liquide comprenant les précurseurs dans le cas où ces derniers sont dissous dans un solvant.

On vient de décrire différents détails relatifs à la formation de la couche 7 de barrière environnementale par la technique DLI-MOCVD. Une fois cette couche 7 formée, elle peut subir un ou plusieurs post-traitements qui vont à présent être décrits.

On peut ainsi soumettre la couche 7 à un traitement de décarburation afin d'éliminer le carbone résiduel apporté par les ligands des précurseurs moléculaires. Le traitement de décarburation peut être réalisé sous atmosphère oxydante, laquelle peut comprendre du dioxygène, du monoxyde de carbone ou du protoxyde d'azote. La température imposée lors du traitement de décarburation peut être comprise entre 800°C et 1350°C, par exemple entre 900°C et 1100°C. La durée du traitement de décarburation peut être comprise entre 30 minutes et 5 heures. Si la durée est trop longue, le traitement de cristallisation peut être amorcé. L'homme du métier travaillera en couple (temps, température) en ayant tendance à augmenter la durée de traitement lorsque la température est basse et inversement.

En variante ou en combinaison, la couche 7 peut subir un traitement thermique de cristallisation afin de réduire la proportion de phase amorphe présente. Le traitement thermique de cristallisation peut être réalisé à une température supérieure ou égale à 1250°C, par exemple à 1350°C, par exemple comprise entre 1300°C et 1350°C. La durée du traitement thermique de cristallisation peut être supérieure ou égale à 5 heures, par exemple supérieure ou égale à 25 heures, par exemple comprise entre 5 heures et 50 heures. A titre d'exemple pour une couche 7 de disilicate d'yttrium, le traitement thermique de cristallisation peut être réalisé à une température de 1350°C pendant au moins cinq heures.

La pièce 1 ainsi fabriquée peut être une pièce pour application aéronautique ou aérospatiale. La pièce 1 peut être une pièce de partie chaude d'une turbine à gaz d'un moteur aéronautique ou aérospatial ou d'une turbine industrielle. La pièce 1 peut être une pièce de turbomachine. La pièce 1 peut constituer une partie au moins d'un distributeur, une partie au moins d'une tuyère ou d'un revêtement de protection thermique, une paroi d'une chambre de combustion, un secteur d'anneau de turbine ou une aube de turbomachine.

Une fois obtenue, la pièce 1 est utilisée à haute température, supérieure ou égale à 800°C, dans une atmosphère oxydante et corrosive. On peut, en particulier, l'utiliser à une température comprise entre 800°C et 1500°C, voire entre 800°C et 1300°C. La pièce 1 peut, en particulier, être utilisée sous air humide.

L'exemple qui vient d'être décrit concerne une pièce 1 ayant une couche 7 de barrière environnementale ayant une composition homogène. La couche de barrière environnementale peut en variante avoir une composition évolutive lorsque la nature et/ou les proportions relatives des précurseurs moléculaires sont modifiées durant le dépôt. Une pièce 11 ayant une couche 17 de barrière environnementale de composition évolutive est illustrée à la figure 2. La couche 17 de barrière environnementale comprend deux portions 17a et 17b superposées ayant une composition différente. La transition de la portion 17a à la portion 17b peut être continue. Selon un exemple, la portion 17a peut comprendre un disilicate de terre rare et la portion 17b un monosilicate de terre rare. L'élément terre rare du monosilicate peut être identique ou différent de l'élément terre rare du disilicate. Dans le cas d'un monosilicate superposé à un disilicate, le disilicate peut être un disilicate d'yttrium et le monosilicate un monosilicate d'ytterbium. En variante ou en combinaison, la portion 17a peut comprendre un silicate d'un premier terre rare et la portion 17b un silicate d'un deuxième terre rare, différent du premier terre rare.

Les caractéristiques du matériau 13 CMC, de la couche d'accrochage 15 peuvent être telles que décrites en lien avec la figure 1.

Par ailleurs, les exemples qui viennent d'être décrits, en lien avec les figures 1 et 2, présentent une couche 7 ou 17 de barrière environnementale formant la surface externe de la pièce revêtue, la couche 7 ou 17 étant la couche de revêtement la plus éloignée du matériau 3 CMC. On ne sort néanmoins pas du cadre de l'invention si ce n'est pas le cas, la couche de barrière environnementale pouvant être revêtue par un revêtement supplémentaire, par exemple de barrière thermique.

### Exemple

Un essai a été réalisé par les inventeurs en utilisant un évaporateur chauffé à 175°C avec injection séparée pour chaque solution. La chambre réactionnelle était un réacteur à paroi froide dans lequel était présent un substrat de silicium posé sur un porte-échantillon (« suscepteur ») chauffé par des lampes halogènes. La température imposée était de 680°C et la pression imposée dans la chambre réactionnelle de 2,67 mbar.

Le précurseur d'oxyde de terre rare utilisé était le Y(thd)₃ dissous à raison de 0,01 M dans le toluène. Le débit d'injection de cette solution dans l'évaporateur était de 0,75 g/min. Le débit du gaz porteur (Ar) pour cette solution était de 300 centimètre cube standard par minute (« sccm »).

Le précurseur d'oxyde de silicium utilisé était le di-t-butoxydiacétoxysilane (DADBS) dissous à raison de 0,01 M dans le toluène. Le débit d'injection de cette solution dans l'évaporateur était de 0,5 g/min. Le débit du gaz porteur (Ar) pour cette solution était de 300 sccm.

Le rapport [quantité molaire Y(thd)₃] / [quantité molaire DADBS] était égal à 1,46. Un débit de O₂ introduit dans la chambre réactionnelle était de 40% de 400 sccm et un débit de N₂ introduit dans la chambre réactionnelle était de 60% de 400 sccm. Le rapport [quantité molaire de O₂ injecté] / [quantité molaire de toluène contenant les précurseurs dissous] était de 0,66. La composition atomique approximative du dépôt obtenu mesurée par spectroscopie photoélectronique par rayons X était la suivante : Y : 23%, Si : 19%, O : 56%, C : 2%.

L'expression « compris(e) entre ... et ... » doit se comprendre comme incluant les bornes.

## Revendications

1. Procédé de fabrication d'une pièce (1 ; 11) à résistance améliorée à l'oxydation et à la corrosion à haute température, comprenant au moins la formation d'une couche (7 ; 17) de barrière environnementale sur un matériau (3 ; 13) composite à matrice au moins partiellement en céramique, ladite couche de barrière environnementale étant formée par dépôt chimique en phase vapeur de composé(s) organométallique(s) par injection directe liquide.

2. Procédé selon la revendication 1, dans lequel la couche (7 ; 17) de barrière environnementale comprend un silicate de terre rare et est formée au moins à partir d'un précurseur d'oxyde de silicium alcoxysilane et d'un précurseur d'oxyde de terre rare béta-dicétonate de terre rare en présence d'une source gazeuse apporteuse d'oxygène.

3. Procédé selon la revendication 1 ou 2, dans lequel la nature et/ou les proportions relatives de précurseurs moléculaires sont modifiées durant la formation de la couche (17) de barrière environnementale de sorte à lui conférer une composition évolutive (17a ; 17b).

4. Procédé selon la revendication 3, dans lequel la formation de la couche (17) de barrière environnementale comprend au moins la formation d'une première portion (17a) comprenant un disilicate de terre rare, et la formation d'une deuxième portion (17b) comprenant un monosilicate de terre rare sur la première portion.

5. Procédé selon la revendication 3, dans lequel la formation de la couche de barrière environnementale comprend au moins la formation d'une première portion comprenant un monosilicate de terre rare, et la formation d'une deuxième portion comprenant un disilicate de terre rare sur la première portion.

6. Procédé selon l'une quelconque des revendications 3 à 5, dans lequel la formation de la couche (17) de barrière environnementale comprend au moins la formation d'une première portion (17a) comprenant un silicate d'un premier terre rare, et la formation d'une deuxième portion (17b) comprenant un silicate d'un deuxième terre rare, différent du premier terre rare, les première et deuxième portions étant superposées.

7. Procédé selon l'une quelconque des revendications 1 à 6, dans lequel l'épaisseur (e₁) de la couche (7 ; 17) de barrière environnementale est inférieure ou égale à 1000 µm.

8. Procédé selon l'une quelconque des revendications 1 à 7, dans lequel le procédé comprend en outre le dépôt d'une couche (5 ; 15) d'accrochage comprenant du silicium sur la surface externe (S) du matériau (3 ; 13) composite à matrice au moins partiellement en céramique, et dans lequel la couche (7 ; 17) de barrière environnementale est déposée sur ladite couche d'accrochage.

9. Procédé selon la revendication 8, dans lequel la couche d'accrochage (5 ; 15) est déposée par dépôt chimique en phase vapeur.

10. Procédé selon l'une quelconque des revendications 1 à 9, dans lequel on réalise en outre un traitement thermique de cristallisation de la couche (7 ; 17) de barrière environnementale formée.

11. Procédé selon l'une quelconque des revendications 1 à 10, dans lequel la pièce (1 ; 11) est une pièce de turbomachine.

## Patentansprüche

1. Verfahren zur Herstellung eines Teils (1; 11) mit verbesserter Beständigkeit gegen Oxidation und Korrosion bei hoher Temperatur, umfassend zumindest die Bildung einer Umweltbarriereschicht (7; 17) auf einem Matrixverbundmaterial (3; 13), das zumindest teilweise aus Keramik besteht, wobei die Umweltbarriereschicht durch chemische Gasphasenabscheidung von einer oder mehreren metallorganischen Verbindungen durch direkte Flüssigkeitseinspritzung gebildet wird.

2. Verfahren nach Anspruch 1, wobei die Umweltbarriereschicht (7; 17) ein Seltenerdsilikat umfasst und zumindest aus einem Vorläufer von Alkoxysilan-Siliziumoxid und einem Vorläufer von Seltenerdoxid-Beta-Diketonat aus seltenen Erden in Gegenwart einer gasförmigen Quelle, die Sauerstoff liefert, gebildet wird.

3. Verfahren nach Anspruch 1 oder 2, wobei die Art und/oder die relativen Anteile der molekularen Vorläufer während der Bildung der Umweltbarriereschicht (17) modifiziert werden, um ihr eine sich entwickelnde Zusammensetzung (17a; 17b) zu verleihen.

4. Verfahren nach Anspruch 3, wobei die Bildung der Umweltbarriereschicht (17) zumindest die Bildung eines ersten Abschnittes (17a), der ein Seltenerd-Disilikat umfasst, und die Bildung eines zweiten Abschnittes (17b), der ein Seltenerdmonosilikat umfasst, auf dem ersten Abschnitt umfasst.

5. Verfahren nach Anspruch 3, wobei die Bildung der Umweltbarriereschicht zumindest die Bildung eines ersten Abschnittes, der ein Seltenerdmonosilikat umfasst, und die Bildung eines zweiten Abschnittes, der ein Seltenerd-Disilikat umfasst, auf dem ersten Abschnitt umfasst.

6. Verfahren nach einem der Ansprüche 3 bis 5, wobei die Bildung der Umweltbarriereschicht (17) zumindest die Bildung eines ersten Abschnittes (17a), der ein Silikat einer ersten seltenen Erde umfasst, und die Bildung eines zweiten Abschnittes (17b), der ein Silikat einer zweiten seltenen Erde umfasst, die sich von der ersten seltenen Erde unterscheidet, wobei der erste und der zweite Abschnitt übereinander liegen, umfasst.

7. Verfahren nach einem der Ansprüche 1 bis 6, wobei die Dicke (e₁) der Umweltbarriereschicht (7; 17) kleiner als oder gleich 1000 µm ist.

8. Verfahren nach einem der Ansprüche 1 bis 7, wobei das Verfahren ferner die Abscheidung einer Verbindungsschicht (5; 15), die Silizium umfasst, auf der Außenfläche (S) des Matrixverbundmaterials (3; 13), die zumindest teilweise aus Keramik besteht, umfasst, und wobei die Umweltbarriereschicht (7; 17) auf der Verbindungsschicht abgeschieden wird.

9. Verfahren nach Anspruch 8, wobei die Verbindungsschicht (5; 15) durch chemische Gasphasenabscheidung abgeschieden wird.

10. Verfahren nach einem der Ansprüche 1 bis 9, wobei ferner eine Wärmebehandlung zur Kristallisation der gebildeten Umweltbarriereschicht (7; 17) umgesetzt wird.

11. Verfahren nach einem der Ansprüche 1 bis 10, wobei das Teil (1; 11) ein Turbomaschinenteil ist.

## Claims

1. A method for producing a part (1; 11) having improved resistance to oxidation and high temperature-corrosion, comprising at least the formation of an environmental barrier coating (7; 17) on an at least partially ceramic matrix composite material (3; 13), said environmental barrier coating being formed by direct liquid injection-metal organic chemical vapor deposition.

2. The method according to claim 1, wherein the environmental barrier coating (7; 17) comprises a rare earth silicate and is formed at least from an alkoxysilane silicon oxide precursor and a rare earth beta-diketonate rare earth oxide precursor in the presence of an oxygen-supplying gas source.

3. The method according to claim 1 or 2, wherein the nature and/or the relative proportions of molecular precursors are modified during the formation of the environmental barrier coating (17) so as to give it a changing composition (17a; 17b).

4. The method according to claim 3, wherein forming the environmental barrier coating (17) comprises at least forming a first portion (17a) comprising a rare earth disilicate, and forming a second portion (17b) comprising a rare earth monosilicate over the first portion.

5. The method according to claim 3, wherein forming the environmental barrier coating comprises at least forming a first portion comprising a rare earth monosilicate, and forming a second portion comprising a rare earth disilicate over the first portion

6. The method according to any of claims 3 to 5, wherein forming the environmental barrier coating (17) comprises at least forming a first portion (17a) comprising a first rare earth silicate, and forming a second portion (17b) comprising a second rare earth silicate, different from the first rare earth, the first and second portions being superimposed.

7. The method according to any one of claims 1 to 6, wherein the thickness (e₁) of the environmental barrier coating (7; 17) is less than or equal to 1000 µm.

8. The method according to any one of claims 1 to 7, wherein the method further comprises depositing a bonding coating (5; 15) comprising silicon on the external surface (S) of the at least partially ceramic matrix composite material (3; 13), and wherein the environmental barrier coating (7; 17) is deposited on said bonding coating.

9. The method according to claim 8, wherein the bonding coating (5; 15) is deposited by chemical vapor deposition.

10. The method according to any one of claims 1 to 9, wherein a thermal crystallization treatment of the environmental barrier coating (7; 17) formed is also carried out.

11. The method according to any one of claims 1 to 10, wherein the part (1; 11) is a turbomachine part.
